# EUROPEAN PATENT APPLICATION

(11) **EP 4 739 052 A1**
(43) Date of publication of application: **06.05.2026**
(21) Application number: 25201739.7
(22) Date of filing: 11.09.2025
(51) Int. Cl.: H10K 59/122, H10K 59/80

(54) **DISPLAY DEVICE AND ELECTRONIC DEVICE**

(30) Priority: 30.10.2024 KR 20240150921
(71) Applicant: Samsung Display Co., Ltd., Yongin-si, Gyeonggi-do 17113 (KR)
(72) Inventor: MOON, Youngmin, 17113 Yongin-si (KR); KIM, Arong, 17113 Yongin-si (KR); PARK, Jonghee, 17113 Yongin-si (KR); PARK, Heemin, 17113 Yongin-si (KR); YANG, Sukyoung, 17113 Yongin-si (KR); YANG, Heejun, 17113 Yongin-si (KR); LEE, Samin, 17113 Yongin-si (KR); CHO, Wonje, 17113 Yongin-si (KR); CHA, Gwangmin, 17113 Yongin-si (KR); CHOI, Daewon, 17113 Yongin-si (KR)
(74) Representative: Marks & Clerk LLP

(57) **Abstract**

A display device includes: a substrate; a circuit layer disposed on the substrate; a first electrode disposed on the circuit layer; a pixel defining layer disposed on a portion of the circuit layer and the first electrode, wherein an opening is defined in the pixel defining layer; a first light-emitting layer disposed on the first electrode and a portion of the pixel defining layer, wherein at least a portion of the first light-emitting layer overlaps the opening in a plan view; a protective layer disposed on the first light-emitting layer and overlapping the pixel defining layer in the plan view; a capping layer covering a side portion of the first light-emitting layer; and a second electrode disposed on the first light-emitting layer and the capping layer. The protective layer includes a first protective layer disposed on the first light-emitting layer and a second protective layer disposed on the first protective layer and having greater etch resistance than the capping layer.

## Description

### BACKGROUND

### 1. Field

The present disclosure relates to a display device, an electronic device, and a method for manufacturing a display device. More specifically, the disclosure pertains to a display device that is structured to prevent damage to the light-emitting layer and disconnection of electrodes, employs a process advantageous for scalability, enhances device reliability, and is suitable for large-scale display devices, as well as an electronic device employing such a display device and a method for manufacturing such a display device.

### 2. Description of the Related Art

In general, display devices are manufactured through multiple stages of processing, and masks may be used in a plurality of stages to form thin-film patterns. When forming the thin-film patterns, a display device may be manufactured using internal components as masks instead of using external masks to provide advantages for scalability.

Accordingly, methods have been studied to pattern certain components of display devices, particularly light-emitting layers, using internal components of the display device as masks rather than using external masks.

### SUMMARY

An embodiment of the present disclosure is to provide a display device with enhanced reliability and scalability.

Another embodiment of the present disclosure is to provide an electronic device with enhanced reliability and scalability.

Yet another embodiment of the present disclosure is to provide a method for manufacturing a display device with enhanced reliability and scalability.

A display device according to an embodiment of the present disclosure includes a substrate, a circuit layer, a first electrode, a pixel defining layer, a first light-emitting layer, a protective layer, a capping layer, and a second electrode.

In an embodiment, the circuit layer is disposed on the substrate.

In an embodiment, the first electrode is disposed on the circuit layer.

In an embodiment, the pixel defining layer is disposed on the circuit layer and the first electrode, and an opening is defined in the pixel defining layer.

In an embodiment, the first light-emitting layer is disposed on the first electrode and a portion of the pixel defining layer, and at least a portion of the first light-emitting layer overlaps the opening in a plan view.

In an embodiment, the protective layer is disposed on the first light-emitting layer and overlap the pixel defining layer.

In an embodiment, the capping layer covers a side portion of the first light-emitting layer.

In an embodiment, the second electrode is disposed on the first light-emitting layer and the capping layer.

In an embodiment, the protective layer includes a first protective layer disposed on the first light-emitting layer and a second protective layer disposed on the first protective layer and having greater etch resistance than the capping layer.

In an embodiment, one side of the first protective layer, which is farther from the opening, and one side of the second protective layer, which is farther from the opening may protrude farther away from the opening than one side of the first light-emitting layer, which is farther from the opening, does.

In an embodiment, a portion of the capping layer may be disposed beneath a protruded side portion of the first protective layer.

In an embodiment, the portion of the capping layer may be in direct contact with the first light-emitting layer.

In an embodiment, the second protective layer may have a smaller width than the first protective layer.

In an embodiment, the capping layer may contact an upper surface of the pixel defining layer and an upper surface of the second protective layer.

In an embodiment, a lower surface of the second electrode may be in direct contact with the first protective layer, the second protective layer, and the capping layer.

In an embodiment, the display device may further include a second light-emitting layer spaced apart from the first light-emitting layer and disposed on another portion of the pixel defining layer.

In an embodiment, a side surface of the first light-emitting layer and a side surface of the second light-emitting layer may overlap the pixel defining layer in the plan view.

In an embodiment, the capping layer may cover the side surface of the first light-emitting layer and the side surface of the second light-emitting layer.

In an embodiment, the protective layer may further include a third protective layer disposed on the second light-emitting layer and a fourth protective layer disposed on the third protective layer and having greater etch resistance than the capping layer.

In an embodiment, the side surface of the first light-emitting layer, the side surface of the second light-emitting layer, a side surface of the first protective layer, a side surface of the second protective layer, a side surface of the third protective layer, and a side surface of the fourth protective layer may overlap the pixel defining layer in the plan view.

In an embodiment, the capping layer may cover the side surface of the first light-emitting layer, the side surface of the second light-emitting layer, the side surface of the first protective layer, the side surface of the second protective layer, the side surface of the third protective layer, and the side surface of the fourth protective layer.

In an embodiment, the first protective layer may include an inorganic material.

In an embodiment, the inorganic material may include at least one selected from silicon nitride (SiNx), silicon oxynitride (SiOxNy), and silicon oxide (SiOx).

In an embodiment, the second protective layer may include a metal oxide.

In an embodiment, the metal oxide may include at least one selected from indium tin oxide (ITO), indium zinc oxide (IZO), indium gallium zinc oxide (IGZO), indium tin gallium oxide (ITGO), and indium tin gallium zinc oxide (ITGZO).

In an embodiment, the first protective layer may include a plurality of silicon-rich first silicon nitride layers, which are silicon rich, and a plurality of nitrogen-rich second silicon nitride layers, which are nitrogen rich.

In an embodiment, the first silicon nitride layers and the second silicon nitride layers may be alternately arranged.

In an embodiment, the capping layer may be defined by a single inorganic layer.

In an embodiment, the capping layer and the pixel defining layer may each include an inorganic material.

In an embodiment, the capping layer and the pixel defining layer may be in contact with each other.

In an embodiment, the display device may further include a transparent electrode layer disposed on the second electrode.

In an embodiment, the first light-emitting layer may emit light in a first wavelength band and the second light-emitting layer may emit light in a second, different wavelength band.

In an embodiment, the first light-emitting layer and the second light-emitting layer may not overlap each other in the plan view.

A display device according to another embodiment of the present disclosure includes a substrate, a circuit layer, a plurality of first electrodes, a pixel defining layer, a first light-emitting layer, a second light-emitting layer, a capping layer, a first protective layer, a second protective layer, a third protective layer, a fourth protective layer, and a second electrode.

In an embodiment, the circuit layer may be disposed on the substrate.

In an embodiment, the pixel defining layer may be disposed between the plurality of first electrodes.

In an embodiment, the first light-emitting layer may be disposed on a first electrode of the first electrodes.

In an embodiment, the second light-emitting layer may be disposed on another first electrode of the first electrodes adjacent to the first electrode where the first light-emitting layer is disposed.

In an embodiment, the capping layer may be disposed on the pixel defining layer.

In an embodiment, the first protective layer may be disposed on the first light-emitting layer.

In an embodiment, the second protective layer may be disposed on the first protective layer and have greater etch resistance than the capping layer.

In an embodiment, the third protective layer may be disposed on the second light-emitting layer.

In an embodiment, the fourth protective layer may be disposed on the third protective layer and have greater etch resistance than the capping layer.

In an embodiment, the second electrode may cover the first light-emitting layer, the first protective layer, the second protective layer, the capping layer, the third protective layer, the fourth protective layer, and the second light-emitting layer.

In an embodiment, the first protective layer and the third protective layer may each include at least one selected from silicon nitride (SiNx), silicon oxynitride (SiOxNy), and silicon oxide (SiOx).

In an embodiment, the second protective layer and the fourth protective layer may each include at least one selected from indium tin oxide (ITO), indium zinc oxide (IZO), indium gallium zinc oxide (IGZO), indium tin gallium oxide (ITGO), and indium tin gallium zinc oxide (ITGZO).

A method for manufacturing a display device according to an embodiment of the present disclosure includes forming a pixel defining layer, forming a first preliminary light-emitting layer, forming a first intermediate protective layer, forming a second intermediate protective layer, and forming a first light-emitting layer.

In an embodiment, in the forming of the pixel defining layer, a display panel including a substrate, a circuit layer disposed on the substrate, and a first electrode disposed on the circuit layer, may be prepared, and a pixel defining layer may be formed on the circuit layer and at least a portion of the first electrode.

In an embodiment, in the forming of the first preliminary light-emitting layer, the first preliminary light-emitting layer may be formed on the first electrode and the pixel defining layer.

In an embodiment, in the forming of the first intermediate protective layer, the first intermediate protective layer may be formed to cover a portion of the first preliminary light-emitting layer overlapping a first light-emitting region.

In an embodiment, the first light-emitting region may emit light in a first wavelength band.

In an embodiment, in the forming of the second intermediate protective layer, the second intermediate protective layer may be formed to overlap the first intermediate protective layer in a plan view.

In an embodiment, the second intermediate protective layer may have greater etch resistance than the first intermediate protective layer.

In an embodiment, in the forming of the first light-emitting layer, the first intermediate protective layer and the second intermediate protective layer may be used as masks to pattern the first preliminary light-emitting layer and form the first light-emitting layer.

In an embodiment, the method may further include, after the forming the first preliminary light-emitting layer and before the forming the first intermediate protective layer, forming a first preliminary protective layer and a second preliminary protective layer on the first preliminary light-emitting layer, and forming a photoresist on a portion of the second preliminary protective layer overlapping the first light-emitting region.

In an embodiment, in the forming of the first light-emitting layer, the photoresist and a portion of the first preliminary light-emitting layer not overlapping the photoresist may be removed in a single dry ashing process.

In an embodiment, the method may further include forming a second preliminary light-emitting layer, forming a third intermediate protective layer, forming a fourth intermediate protective layer, and forming a second light-emitting layer.

In an embodiment, in the forming of the second preliminary light-emitting layer, the second preliminary light-emitting layer may be formed on the first electrode, the pixel defining layer, and the first light-emitting layer, after the forming the first light-emitting layer.

In an embodiment, in the forming of the third intermediate protective layer, the third intermediate protective layer may be formed to cover a portion of the second preliminary light-emitting layer overlapping a second light-emitting region.

In an embodiment, the second light-emitting region emit light in a second wavelength band, different from the first wavelength band, and may be spaced apart from the first light-emitting region.

In an embodiment, in the forming of the fourth intermediate protective layer, the fourth intermediate protective layer may be formed to overlap the third intermediate protective layer in the plan view.

In an embodiment, the fourth intermediate protective layer may have greater etch resistance than the third intermediate protective layer.

In an embodiment, in the forming of the second light-emitting layer, the third intermediate protective layer and the fourth intermediate protective layer may be used as masks to pattern the second preliminary light-emitting layer and form the second light-emitting layer.

In an embodiment, the method may further include forming a preliminary capping layer and forming a capping layer.

In an embodiment, in the forming of the preliminary capping layer, the preliminary capping layer may be formed on the first light-emitting layer, the pixel defining layer, the first intermediate protective layer, the second intermediate protective layer, the second light-emitting layer, the third intermediate protective layer, and the fourth intermediate protective layer, after forming the second light-emitting layer.

In an embodiment, the second intermediate protective layer and the fourth intermediate protective layer may each have greater etch resistance than the preliminary capping layer.

In an embodiment, in the forming of the capping layer, the preliminary capping layer may be patterned to overlap non-light-emitting regions between the first light-emitting region and the second light-emitting region and contact the first light-emitting layer and the second light-emitting layer.

In an embodiment, the method may further include forming the second protective layer and the fourth protective layer, exposing the first light-emitting region and the second light-emitting region, and forming a second electrode.

In an embodiment, in the forming of the second protective layer and the fourth protective layer, the second protective layer and the fourth protective layer may be formed by removing portions of the second intermediate protective layer and the fourth intermediate protective layer not overlapping the capping layer in the plan view, after the forming the capping layer.

In an embodiment, in the exposing of the first light-emitting region and the second light-emitting region, the first protective layer and the third protective layer may be formed, and the first light-emitting region and the second light-emitting region may be exposed, by removing portions of the first intermediate protective layer and the third intermediate protective layer not overlapping the capping layer in the plan view.

In an embodiment, in the forming of the second electrode, the second electrode may be formed on the capping layer, the first protective layer, the second protective layer, the third protective layer, the fourth protective layer, the first light-emitting layer, and the second light-emitting layer.

An electronic device according to an embodiment of the present disclosure includes a substrate, a circuit layer, a first electrode, a pixel defining layer, a first light-emitting layer, a protective layer, a capping layer, and a second electrode.

In an embodiment, the circuit layer may be disposed on the substrate.

In an embodiment, the first electrode may be disposed on the circuit layer.

In an embodiment, the pixel defining layer may be disposed on the circuit layer and the first electrode, and an opening may be defined in the pixel defining layer.

In an embodiment, the first light-emitting layer may be disposed on the first electrode and the pixel defining layer, where a portion of the first light-emitting layer may overlap the opening in a plan view.

In an embodiment, the protective layer may be disposed on the first light-emitting layer and overlap the pixel defining layer.

In an embodiment, the capping layer may cover a side portion of the first light-emitting layer.

In an embodiment, the second electrode may be disposed on the first light-emitting layer and the capping layer.

In an embodiment, the protective layer may include a first protective layer disposed on the first light-emitting layer and a second protective layer disposed on the first protective layer and having greater etch resistance than the capping layer.

At least some of the above and other features of the invention are set out in the claims.

According to embodiments of the present disclosure, certain components within the display device may be used as masks, thereby providing a display device, an electronic device, and a method of manufacturing a display device that are advantageous for scalability and have improved reliability.

### BRIEF DESCRIPTION OF THE DRAWINGS

These and/or other features will become apparent and more readily appreciated from the following description of the embodiments, taken in conjunction with the accompanying drawings in which:
FIG. 1 is a plan view of a display device according to an embodiment of the present disclosure;
FIG. 2 is a cross-sectional view taken along I-I' line of FIG. 1;
FIG. 3 is an enlarged view of the AA region of FIG. 2;
FIG. 4 is an enlarged view of the AA region of FIG. 2 in a display device according to an embodiment of the present disclosure;
FIG. 5 is an enlarged view of the AA region of FIG. 2 in a display device according to an embodiment of the present disclosure;
FIG. 6 is an enlarged view of the BB region of FIG. 2;
FIG. 7 is a cross-sectional view showing a portion of the first protective layer according to an embodiment of the present disclosure;
FIG. 8 is a cross-sectional view showing a portion of a display device according to an embodiment of the present disclosure;
FIG. 9 is a flow diagram illustrating a method for manufacturing a display device according to an embodiment of the present disclosure;
FIG. 10 is a partial flow diagram illustrating a section of the method for manufacturing a display device according to an embodiment of the present disclosure;
FIGS. 11A to 11Z are schematic cross-sectional views illustrating respective steps in the method for manufacturing a display device according to an embodiment of the present disclosure;
FIG. 12 illustrates electronic devices in which a display device according to an embodiment of the present disclosure is applied; and
FIG. 13 also illustrates electronic devices in which a display device according to an embodiment of the present disclosure is applied.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

When an element (or region, layer, portion, etc.) is described to be "disposed on," "placed on," "arranged on," "connected to," or "coupled to" another element, it shall be construed as being disposed on, placed on, arranged on, connected to, or coupled to the other element directly but also as possibly having another element therebetween. On the other hand, if one element is described to be "directly disposed on," "directly placed on," "directly arranged on," "directly connected to," or "directly coupled to" another element, it shall be construed that there is no other element interposed therebetween.

Like or identical reference numerals refer to like or identical elements. Moreover, in the accompanying drawings, the thicknesses, ratios, and dimensions of the elements may not be to exact scale and may have been exaggerated for the benefit of effective explanation of the technical features associated with these elements. As such, the present disclosure shall not be restricted to the thicknesses, ratios, dimensions, etc. illustrated in the drawings.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

In the present specification, when a particular process sequence may be implemented differently, the described sequence of processes may be performed in a different order. For example, two sequentially described processes may be performed substantially simultaneously, or the order of description may be reversed.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

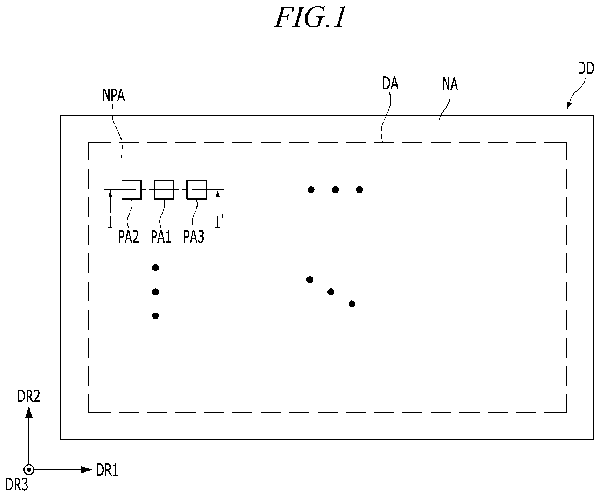

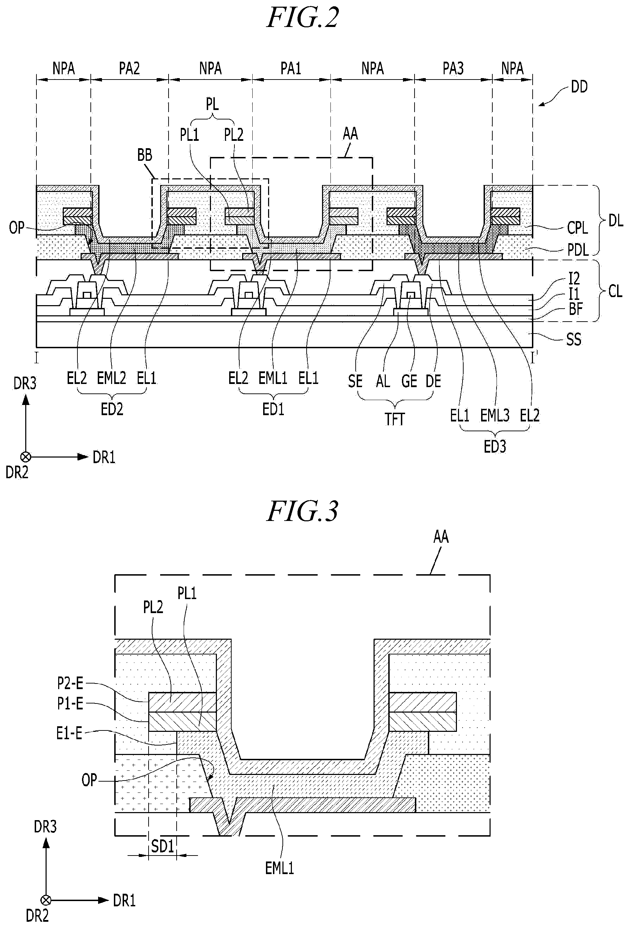

First through third directions DR1, DR2, DR3 may be defined. The first direction DR1 and the second direction DR2 may be directions defined in the plane of the display device DD shown in FIG. 1 and may intersect each other. The third direction DR3 may be the thickness direction of the display device DD, as defined in FIG. 2.

The expression "in a plan view" in this specification may refer to a view along the third direction DR3, i.e., a direction viewing from the top of the structure toward the bottom. Additionally, in this specification, any description based on a particular direction may include not only the direction shown in the drawing but also the concept of an opposite direction to the depicted direction.

FIG. 1 is a plan view of a display device according to an embodiment of the present disclosure. Referring to FIG. 1, the display device DD according to an embodiment of the present disclosure may include a display region DA and a peripheral region NA. The display region DA may be an area where an image is displayed. The peripheral region NA may be an area disposed around the display region DA where no image is displayed. In some embodiments, the peripheral region NA may be omitted.

In an embodiment of the present disclosure, as shown in FIG. 1, the display region DA may have a rectangular shape, and the peripheral region NA may surround the display region DA in a plan view or when viewed in the third direction DR3. However, the planar shapes of the display region DA and the peripheral region NA are not limited thereto and may be variously designed.

FIG. 2 is a cross-sectional view taken along I-I' line of FIG. 1. Referring to FIGS. 1 and 2, in an embodiment, the display region DA may include light-emitting regions PA1, PA2, PA3 and a non-light-emitting region NPA defined therein. The light-emitting regions PA1, PA2, PA3 may be areas that overlap, respectively, light-emitting diodes ED1, ED2, ED3 in a plan view or in the third direction DR3, and light emitted from the light-emitting diodes ED1, ED2, ED3 is displayed in the light-emitting regions PA1, PA2, PA3. The non-light-emitting region NPA may be an area defined between the light-emitting regions PA1, PA2, PA3 and may correspond to the pixel defining layer PDL.

The light-emitting regions PA1, PA2, PA3 may include, but are not limited to, a first light-emitting region PA1, a second light-emitting region PA2, and a third light-emitting region PA3. Light emitted from the first light-emitting diode ED1 may be displayed in the first light-emitting region PA1, light emitted from the second light-emitting diode ED2 may be displayed in the second light-emitting region PA2, and light emitted from the third light-emitting diode ED3 may be displayed in the third light-emitting region PA3.

The light-emitting diodes ED1, ED2, ED3 may each emit a different color of light. In an embodiment, for example, but not limited to the example, the first light-emitting diode ED1 may emit green light, the second light-emitting diode ED2 may emit red light, and the third light-emitting diode ED3 may emit blue light.

Each of the first to third light-emitting regions PA1, PA2, PA3 may be provided in plurality and arranged in a predetermined pattern within the display region DA. In an embodiment, for example, but not limited to this particular example, the first to third light-emitting regions PA1, PA2, PA3 may have a PENTILE^{™} arrangement, a stripe arrangement, or a Diamond Pixel^{™} arrangement.

The first to third light-emitting regions PA1, PA2, PA3 may each have various shapes in a plan view. Although embodiments where the planar shapes of the first to third light-emitting regions PA1, PA2, PA3 are rectangles are illustrated as an example in the accompanying drawings, the planar shapes of the light-emitting regions PA1, PA2, PA3 illustrated in the drawings are merely examples and may be circular, elliptical, polygonal, or other shapes in another embodiment.

In an embodiment, the areas (or sizes) of the first to third light-emitting regions PA1, PA2, PA3 may be the same as each other as shown in the accompanying drawings, but this is illustrated as an example, and the areas may be different from each other in another embodiment.

Referring to FIG. 2, an embodiment of the display device DD may include a substrate SS, a circuit layer CL disposed on the substrate SS, and a display layer DL disposed on the circuit layer CL. The substrate SS may serve as a base surface on which the display layer DL is disposed. The substrate SS may be a glass substrate, a metal substrate, or a plastic substrate. However, the embodiments are not limited thereto, and the substrate SS may be an inorganic layer, an organic layer, or a composite material layer.

The circuit layer CL is disposed on the substrate SS. The circuit layer CL may include transistors TFT, which apply electrical signals to the light-emitting diodes ED1, ED2, ED3 disposed in the display layer DL, a first insulating layer I1, and a second insulating layer I2.

The transistor TFT may include an active layer AL disposed on the substrate SS, a gate electrode GE disposed on at least a portion of the active layer AL, and a source electrode SE and a drain electrode DE disposed on the gate electrode GE and electrically connected to the active layer AL.

The first insulating layer I1 may be disposed between the active layer AL and the gate electrode GE, and the second insulating layer I2 may be disposed on the gate electrode GE.

In an embodiment, the circuit layer CL may further include a buffer layer BF. The buffer layer BF may be disposed between the substrate SS and the active layer AL. The buffer layer BF may provide a modified surface to have stronger adhesion to the transistor TFT. The buffer layer BF may be an inorganic material layer including at least one selected from silicon nitride, silicon oxide, and silicon oxynitride.

The display layer DL may include the pixel defining layer PDL, the light-emitting diodes ED1, ED2, ED3, a protective layer PL, and a capping layer CPL.

Each of the light-emitting diode ED1, ED2, ED3 may include a first electrode EL1, a light-emitting layer EML1, EML2, EML3, and a second electrode EL2. In some embodiments, a hole injection layer (not shown) may be disposed between the first electrode EL1 and the light-emitting layers EML1, EML2, EML3. In some embodiments, an electron injection layer (not shown) may be disposed between the light-emitting layers EML1, EML2, EML3 and the second electrode EL2. However, the locations of the hole injection layer and the electron injection layer are not limited to what is described herein and may be reversed depending on whether the first electrode EL1 and the second electrode EL2 each function as the anode or cathode.

The first electrode EL1 is disposed on the circuit layer CL, may have electrical conductivity and may be electrically connected to the transistor TFT to receive an electrical signal through the transistor TFT.

The light-emitting layers EML1, EML2, EML3 may be disposed on the first electrode EL1. In an embodiment, for example, the first light-emitting layer EML1 that emits green light may be disposed on the first electrode EL1 of the first light-emitting diode ED1, the second light-emitting layer EML2 that emits red light may be disposed on the first electrode EL1 of the second light-emitting diode ED2, and the third light-emitting layer EML3 that emits blue light may be disposed on the first electrode EL1 of the third light-emitting diode ED3. However, the embodiments are not limited the arrangement described above.

The second electrode EL2 may be disposed on the light-emitting layers EML1, EML2, EML3. In an embodiment, the second electrode EL2 may be arranged on and shaped to cover the first light-emitting layer EML1 of the first light-emitting diode ED1, the second light-emitting layer EML2 of the second light-emitting diode ED2, and the third light-emitting layer EML3 of the third light-emitting diode ED3.

In an embodiment, the second electrode EL2 may have an integral shape or be integrally formed as a single unitary indivisible part.

Since the first, second, and third light-emitting diodes ED1, ED2, ED3 may have substantially the same or similar configurations as each other, the configuration of the first light-emitting diode ED1 will be mainly described hereinafter, and any repetitive detailed descriptions of the second and third light-emitting diodes ED2 and ED3 will be omitted.

The protective layer PL includes a first protective layer PL1 and a second protective layer PL2. The first protective layer PL1 may be disposed in the non-light-emitting region NPA and may be disposed on the light-emitting layers EML1, EML2, EML3. In an embodiment, the first protective layer PL1 may be disposed on (or to cover) edges of the light-emitting layers EML1, EML2, EML3 located in the non-light-emitting region NPA. In addition, a portion of the first protective layer PL1 may protrude away from (a center of) an opening OP on the edges of the light-emitting layers EML1, EML2, EML3. Accordingly, the area where the first protective layer PL1 and the pixel defining layer PDL overlap (i.e., an overlapping area of the first protective layer PL1 and the pixel defining layer PDL) may be greater than the area where each of the light-emitting layers EML1, EML2, EML3 and the pixel defining layer PDL overlap (or an overlapping area of each of the light-emitting layers EML1, EML2, EML3 and the pixel defining layer PDL). In a region where the first protective layer PL1 and the light-emitting layers EML1, EML2, EML3 do not overlap in a plan view, at least a portion of the capping layer CPL, which will be described below, may be disposed below the first protective layer PL1, and the side surfaces of the light-emitting layers EML1, EML2, EML3 may be covered or protected by the capping layer CPL. The first protective layer PL1 may be a part of a structure that functions as a mask in the process of patterning the light-emitting layers EML1, EML2, EML3 according to an embodiment of the method for manufacturing the display device DD described below.

The second protective layer PL2 may be disposed in the non-light-emitting region NPA and is disposed on the first protective layer PL1. In an embodiment, the second protective layer PL2 may protrude, along with the first protective layer PL1, from the edges of the light-emitting layers EML1, EML2, EML3, away from (the center of) the opening OP. However, the embodiments are not limited to this configuration, and the second protective layer PL2 may have a smaller width than the first protective layer PL1 and may not protrude beyond the edges of the light-emitting layers EML1, EML2, EML3 in another embodiment. The second protective layer PL2 may also function as part of a structure that serves as a mask during the process of patterning the light-emitting layers EML1, EML2, EML3 according to the method for manufacturing the display device DD described below.

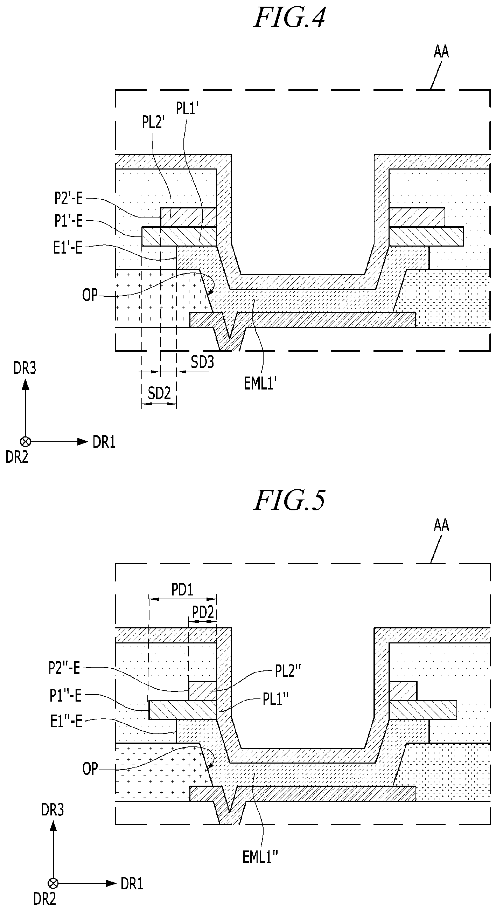

FIG. 3 is an enlarged view of the AA region of FIG. 2. FIG. 4 is an enlarged view of the AA region of FIG. 2 in a display device according to an embodiment of the present disclosure. FIG. 5 is an enlarged view of the AA region of FIG. 2 in a display device according to an embodiment of the present disclosure.

Referring to FIG. 3, in an embodiment, one side (or distal end) P1-E of the first protective layer PL1 that is relatively distal from the opening OP and one side (or distal end) P2-E of the second protective layer PL2 that is relatively distal from the opening OP may be spaced apart from one side (or distal end) E1-E of the first light-emitting layer EML1 that is relatively distal from the opening OP by a predetermined distance SD1 in a plan view. In other words, the one side P1-E of the first protective layer PL1 and the one side P2-E of the second protective layer PL2 may protrude farther away from the opening OP than the one side E1-E of the first light-emitting layer EML1 does. Although FIG. 3 illustrates an embodiment where the one side P1-E of the first protective layer PL1 and the one side P2-E of the second protective layer PL2 overlap (or aligned with) each other in a plan view or in the third direction DR3, the embodiments are not limited to what is illustrated herein.

Referring to FIG. 4, in another embodiment, the one side E1'-E of the first light-emitting layer EML1' may be spaced apart from one side PL1'-E of the first protective layer PL1' and the one side P2'-E of the second protective layer PL2', and the one side PL1'-E of the first protective layer PL1' and the one side P2'-E of the second protective layer PL2' may be spaced apart from each other. Here, the distance SD2 between the one side P1'-E of the first protective layer PL1' and the one side E1'-E of the first light-emitting layer EML1' may be smaller than the distance SD3 between the one side P2'-E of the second protective layer PL2' and the one side E1'-E of the first light-emitting layer EML1'.

Referring to FIG. 5, in another embodiment, the first protective layer PL1" may have a first width PD1, and the second protective layer PL2" may have a second width PD2, and the second width PD2 may be relatively smaller than the first width PD1. In such an embodiment, the one side P1"-E of the first protective layer PL1" may protrude farther away from the opening OP than the one side E1"-E of the first light-emitting layer EML1" does. However, the one side P2"-E of the second protective layer PL2" may not protrude farther away from the opening OP than the one side E1"-E of the first light-emitting layer EML1" does.

The shapes of the first protective layer PL1 and the second protective layer PL2, as described with reference to FIGS. 3 to 5, may result from the differing etch resistance of the first protective layer PL1 and the second protective layer PL2 after the etching process.

In embodiments of the present disclosure, etch resistance may be defined as a measure of the degree to which a material is etched during the etching process. For example, a component having relatively high etch resistance may be etched significantly less than a component with relatively low etch resistance. In other words, if a particular component has relatively high etch resistance compared to another structure, the highly etch-resistant component may be etched to a much lesser degree during the etching process, thereby protecting the component disposed below it during the process.

In an embodiment, the second protective layer PL2 may have greater etch resistance than the first protective layer PL1. In addition, the second protective layer PL2 may have greater etch resistance than the capping layer CPL, which will be described later in greater detail.

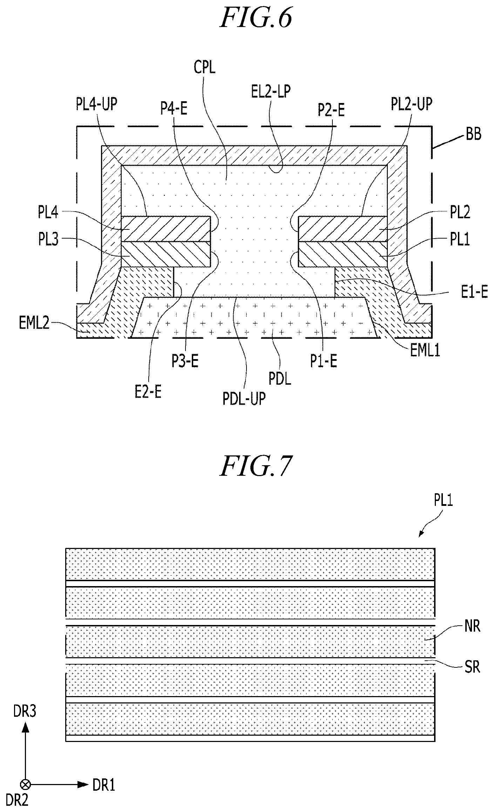

FIG. 6 is a cross-sectional view of the BB region of FIG. 2. Referring to FIG. 6, the capping layer CPL may be disposed on the pixel defining layer PDL. Specifically, the capping layer CPL may be disposed on the pixel defining layer PDL, the second protective layer PL2, and a fourth protective layer PL4, which may be formed in a same process as the second protective layer PL2, and within the non-light-emitting region NPA. Additionally, the capping layer CPL may contact the upper surface PDL-UP of the pixel defining layer PDL, the upper surface PL2-UP of the second protective layer PL2, and the upper surface PL4-UP of the fourth protective layer PL4.

The first light-emitting layer EML1 may be disposed between the pixel defining layer PDL and the first protective layer PL1, and the second light-emitting layer EML2 may be disposed between the pixel defining layer PDL and a third protective layer PL3. Additionally, the one side E1-E of the first light-emitting layer EML1 and the one side E2-E of the second light-emitting layer EML2 may overlap the pixel defining layer PDL in a plan view, in which case, the capping layer CPL may cover the one side E1-E of the first light-emitting layer EML1 and the one side E2-E of the second light-emitting layer EML2, thereby protecting the first light-emitting layer EML1 and the second light-emitting layer EML2 from external exposure. Furthermore, the capping layer CPL may increase the distance between the first electrode EL1 and the second electrode EL2, thereby effectively preventing arc discharge or similar phenomena therebetween.

In an embodiment, the one side E1-E of the first light-emitting layer EML1, the one side P1-E of the first protective layer PL1 disposed on the first light-emitting layer EML1, the one side P2-E of the second protective layer PL2 disposed on the first protective layer PL1, the one side E2-E of the second light-emitting layer EML2, the one side P3-E of the third protective layer PL3 disposed on the second light-emitting layer EML2, and the one side P4-E of the fourth protective layer PL4 disposed on the third protective layer PL3 may all overlap the pixel defining layer PDL in a plan view. In such an embodiment, the capping layer CPL may cover the one side E1-E of the first light-emitting layer EML1, the one side P1-E of the first protective layer PL1, the one side P2-E of the second protective layer PL2, the one side E2-E of the second light-emitting layer EML2, the one side P3-E of the third protective layer PL3, and the one side P4-E of the fourth protective layer PL4.

In other words, the one side E1-E of the first light-emitting layer EML1 and the one side E2-E of the second light-emitting layer EML2 may be spaced apart from and face opposite to each other in the non-light-emitting region NPA in which they overlap the pixel defining layer PDL. The first protective layer PL1 and the second protective layer PL2 may be disposed on a portion of the first light-emitting layer EML1 extending from the one side E1-E. The third protective layer PL3 and the fourth protective layer PL4 may be disposed on a portion of the second light-emitting layer EML2 extending from the one side E2-E. The capping layer CPL may fill the space between the first light-emitting layer EML1, the second light-emitting layer EML2, the pixel defining layer PDL, and the first to fourth protective layers PL1, PL2, PL3, PL4.

In an embodiment, the capping layer CPL may be provided as a single inorganic layer, in which case, the first protective layer PL1, the second protective layer PL2, and the capping layer CPL may each be provided as an inorganic layer, a transparent electrode layer, and another inorganic layer that are successively laminated in cross-section, thereby forming a smooth shape that effectively prevents disconnection of the second electrode EL2.

In a comparative example, the capping layer included in the display device may be formed by atomic layer deposition (ALD) technique and may include organic materials and resins. A capping layer including organic materials and resins may have greater risks of moisture absorption and outgassing compared to a capping layer made of inorganic materials. Additionally, a heat treatment process may be performed afterward to prevent the formation of an undercut structure that causes disconnection of the second electrode. Such a heat treatment process may cause damage to the light-emitting layers.

The capping layer CPL included in the display device according to an embodiment of the present disclosure may be formed using a chemical vapor deposition (CVD) technique and may include an inorganic material, thereby effectively preventing the formation of an undercut structure without performing a subsequent heat treatment process.

In an embodiment, a lower surface EL2-LP of the second electrode EL2 may be in direct contact with the first protective layer PL1, the second protective layer PL2, the third protective layer PL3, the fourth protective layer PL4, and the capping layer CPL. The first to fourth protective layers PL1, PL2, PL3, PL4 and the capping layer CPL may provide a smooth shape that enables the second electrode EL2 to extend stably without being disconnected.

In an embodiment, the first protective layer PL1 and the capping layer CPL may be provided using substantially the same or similar material as each other. Accordingly, the first protective layer PL1 and the capping layer CPL may have substantially the same or similar etch resistance as each other. Additionally, the first protective layer PL1 may be provided using a material having properties for protecting the light-emitting layers EML1, EML2, EML3 during the process of patterning the first light-emitting layer EML1.

In an embodiment, the first protective layer PL1 may include an inorganic material. In an embodiment, the first protective layer PL1 may be provided as an inorganic material including at least one selected from silicon nitride (SiNx), silicon oxide (SiOx), or silicon oxynitride (SiOxNy).

The second protective layer PL2 is provided as a material having relatively greater etch resistance than the capping layer CPL such that damage to the underlying structures may be effectively prevented during the etching step in the process of forming the capping layer CPL. Additionally, the second protective layer PL2 may have greater etch resistance than the first protective layer PL1.

In an embodiment, the second protective layer PL2 may include a metal oxide. In an embodiment, the second protective layer PL2 may include at least one selected from indium tin oxide (ITO), indium zinc oxide (IZO), indium gallium zinc oxide (IGZO), indium tin gallium oxide (ITGO), or indium tin gallium zinc oxide (ITGZO).

The first protective layer PL1 according to an embodiment of the present disclosure may be disposed on the light-emitting layers EML1, EML2, EML3 and may protect the light-emitting layers EML1, EML2, EML3 during the manufacturing process of the display device DD. In an embodiment, the first protective layer PL1, which may include an inorganic material, may be disposed between the second protective layer PL2 and the light-emitting layers EML1, EML2, EML3 to effectively prevent damage to the light-emitting layers EML1, EML2, EML3 during the formation of the second protective layer PL2, which may include a metal oxide.

In an embodiment, the capping layer CPL and the pixel defining layer PDL may each be provided as an inorganic material or defined by an inorganic layer, and the capping layer CPL and the pixel defining layer PDL may be in contact with each other. Accordingly, the one side E1-E of the first light-emitting layer EML1 may be protected from external exposure by overlapping the capping layer CPL and the pixel defining layer PDL, each of which may include an inorganic material.

In an embodiment, the capping layer CPL may be provided as an inorganic material or defined by an inorganic layer including at least one selected from silicon nitride (SiNx), silicon oxide (SiOx), or silicon oxynitride (SiOxNy).

FIG. 7 is a cross-sectional view showing a portion of the first protective layer according to an embodiment of the present disclosure. Referring to FIG. 7, in an embodiment, the first protective layer PL1 may include a plurality of silicon-rich (Si-rich) first silicon nitride layers SR and a plurality of nitrogen-rich (N-rich) second silicon nitride layers NR, and the first silicon nitride layers SR and the second silicon nitride layers NR may be alternately arranged or stacked therein. The first protective layer PL1 may have a structure desired for moisture resistance, thereby effectively preventing the interface from easily oxidizing.

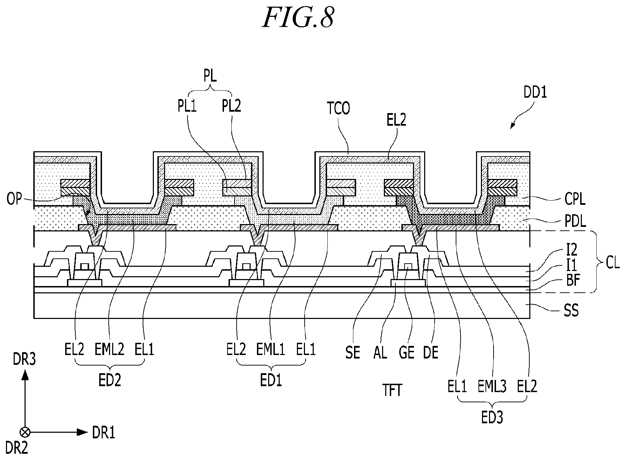

FIG. 8 is a cross-sectional view showing a portion of a display device according to an embodiment of the present disclosure. Referring to FIG. 8, the display device DD1 according to an embodiment may further include a transparent electrode layer TCO disposed on the second electrode EL2. The transparent electrode layer TCO may compensate for the second electrode EL2 to ensure smooth transmission of electrical signals in a case where the second electrode EL2 is not formed with a uniform thickness or disconnection occurs in the second electrode EL2.

In the display device DD1 according to an embodiment of the present disclosure, the first light-emitting layer EML1, the second light-emitting layer EML2, and the third light-emitting layer EML3 may not overlap each other in a plan view. In the manufacturing process of the display device DD1, the light-emitting layers EML1, EML2, EML3 may be formed through blanket deposition and then patterned to form the first light-emitting layer EML1, the second light-emitting layer EML2, and the third light-emitting layer EML3 in a non-overlapping arrangement in a plan view.

In a comparative example, the display device may be manufactured by using a metal mask during the process and patterning each light-emitting layer corresponding to each light-emitting region through deposition. In this structure, the light-emitting layers emitting light in different wavelength bands may overlap each other in a plan view. The use of a metal mask for patterning the light-emitting layers during the manufacturing process may be disadvantageous or undesired for scaling up the display device.

The display device DD1 according to an embodiment of the present disclosure may form the light-emitting layers EML1, EML2, EML3 through a blanket deposition process and a photolithography process that are advantageous or desired for scalability. The display device DD formed through such processes may have a structure in which the light-emitting layers EML1, EML2, EML3 do not overlap each other in a plan view.

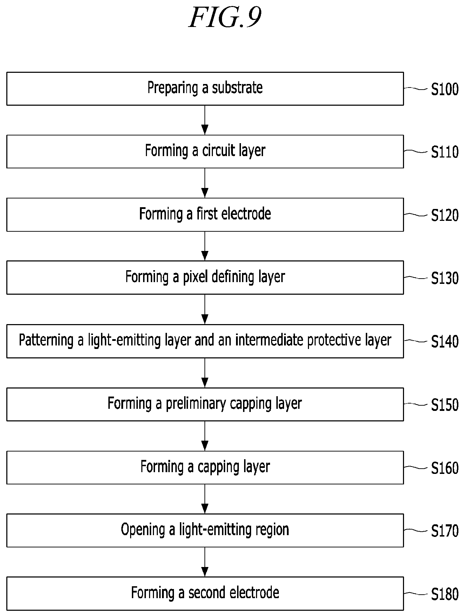

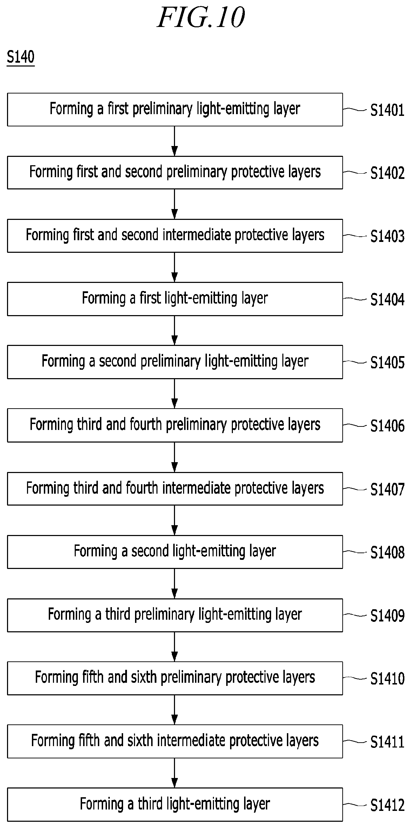

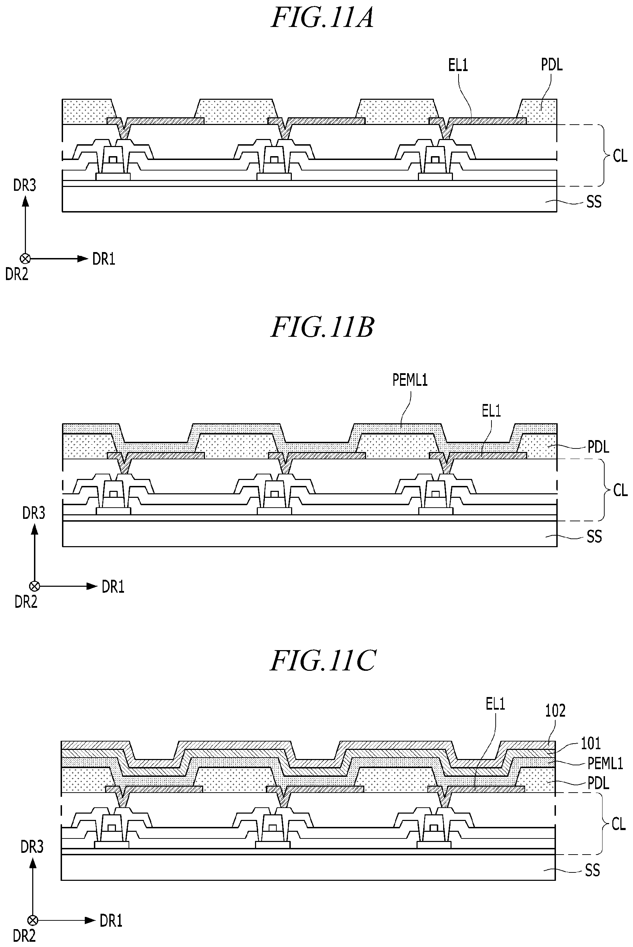

FIG. 9 is a flow diagram illustrating a method for manufacturing a display device according to an embodiment of the present disclosure. FIG. 10 is a partial flow diagram illustrating a section of the method for manufacturing a display device according to an embodiment of the present disclosure. FIGS. 11A to 11Z are schematic cross-sectional views illustrating respective steps in the method for manufacturing a display device according to an embodiment of the present disclosure.

Hereinafter, the method for manufacturing a display device according to an embodiment of the present disclosure will be described with reference to FIGS. 9 to 11Z. The elements described with reference to FIGS. 1 to 8 will be assigned with the same reference numerals and any repetitive detailed description thereof will be omitted or simplified.

Referring to FIG. 9, the method for manufacturing a display device according to an embodiment of the present disclosure may include preparing a substrate (S100), forming a circuit layer (S110), forming a first electrode (S120), forming a pixel defining layer (S130), patterning a light-emitting layer and an intermediate protective layer (S140), forming a preliminary capping layer (S150), forming a capping layer (S160), opening a light-emitting region (S170), and forming a second electrode (S180).

Referring to FIGS. 9 and 11A, in the process of forming a pixel defining layer (S130), a substrate SS may be prepared (S100), a circuit layer CL may be formed on the prepared substrate SS (S110), and a first electrode EL1 may be formed on a portion of the circuit layer CL (S120), and then a pixel defining layer PDL may be formed on the first electrode EL1 and the circuit layer CL.

Referring to FIGS. 9 and 10, the process of patterning a light-emitting layer and an intermediate protective layer (S140) may include forming a first preliminary light-emitting layer (S1401), forming first and second preliminary protective layers (S1402), forming first and second intermediate protective layers (S1403), forming a first light-emitting layer (S1404), forming a second preliminary light-emitting layer (S1405), forming third and fourth preliminary protective layers (S1406), forming third and fourth intermediate protective layers (S1407), forming a second light-emitting layer (S1408), forming a third preliminary light-emitting layer (S1409), forming fifth and sixth preliminary protective layers (S1410), forming fifth and sixth intermediate protective layers (S1411), and forming a third light-emitting layer (S1412).

Referring to FIGS. 10 and 11B, in the process of forming a first preliminary light-emitting layer (S1401), a first preliminary light-emitting layer PEML1 may be formed on the pixel defining layer PDL and the first electrode EL1. In an embodiment, the first preliminary light-emitting layer PEML1 may be blanket deposited using an open mask.

Referring to FIGS. 10 and 11C, in the process of forming first and second preliminary protective layers (S1402), a first preliminary protective layer 101 and a second preliminary protective layer 102 may be successively or sequentially formed on the first preliminary light-emitting layer PEML1. In an embodiment, the first preliminary protective layer 101 and the second preliminary protective layer 102 may be blanket deposited using an open mask. In an embodiment of the present disclosure, the second preliminary protective layer 102 may have relatively greater etch resistance than the first preliminary protective layer 101, and the first preliminary protective layer 101 may include an inorganic material.

In a comparative example, the display device may include a protective layer including a metal oxide directly disposed on the light-emitting layer. The deposition process for the metal oxide protective layer, which is formed using relatively higher energy compared to the deposition of inorganic materials, may cause damage to the light-emitting layer.

In an embodiment of the present disclosure, the first preliminary protective layer 101 may be disposed between the second preliminary protective layer 102 including a metal oxide and the first preliminary light-emitting layer PEML1, thereby effectively preventing damage to the first preliminary light-emitting layer PEML1 during the formation of the second preliminary protective layer 102.

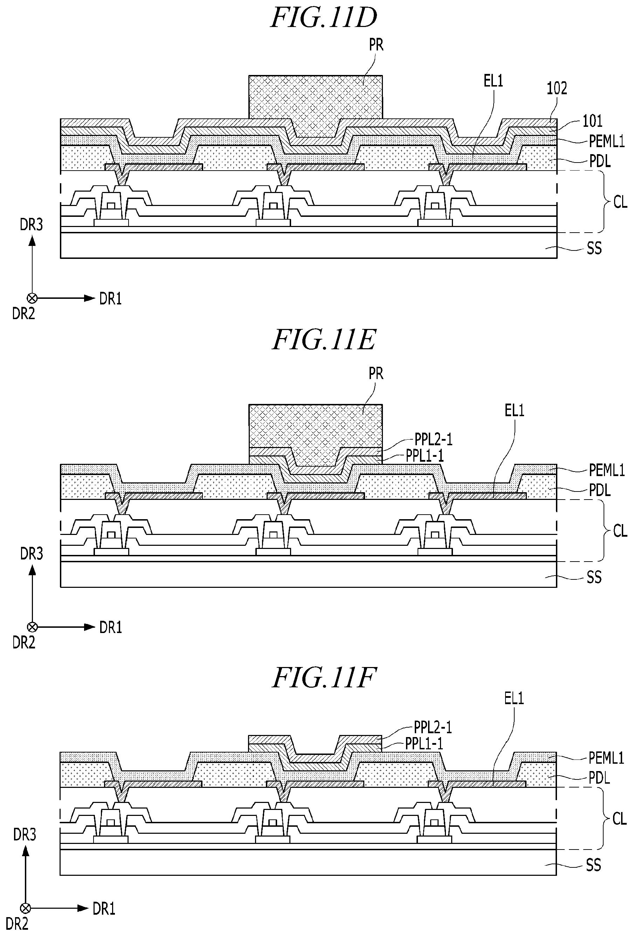

Referring to FIGS. 10 and 11D, in the process of forming first and second intermediate protective layers (S1403), a photoresist PR may first be formed in a region corresponding to (or overlapping) the first light-emitting diode ED1 (see FIG. 2). Referring to FIG. 11E, an etching process may then be performed to form a first intermediate protective layer PPL1-1 and a second intermediate protective layer PPL2-1. Referring to FIG. 11F, the photoresist PR may then be removed.

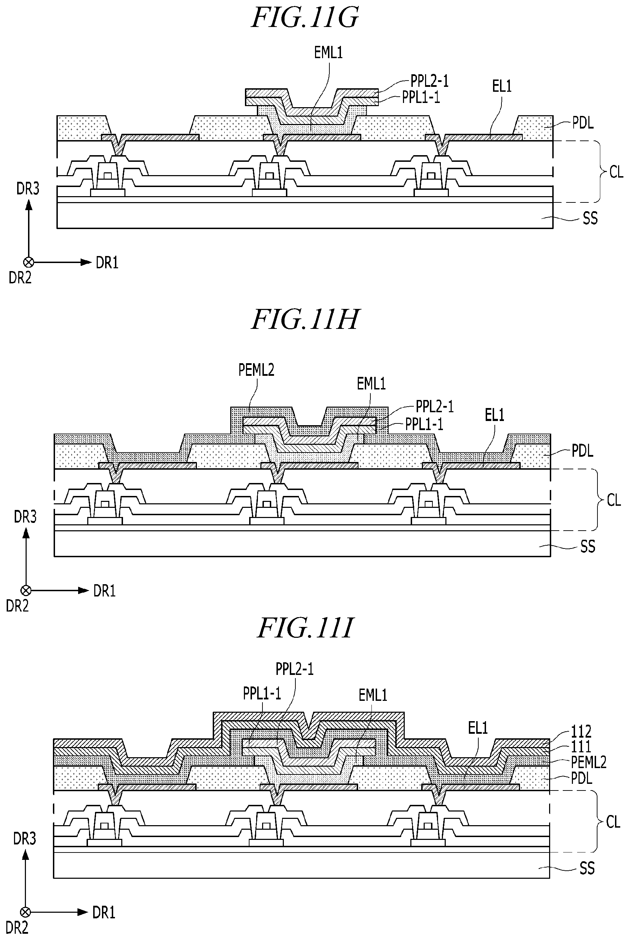

Referring to FIGS. 10 and 11G, in the process of forming a first light-emitting layer (S1404), an etching process may be performed to remove a portion of the first preliminary light-emitting layer PEML1 and form the first light-emitting layer EML1. Here, the first intermediate protective layer PPL1-1 and the second intermediate protective layer PPL2-1 may function as masks for patterning the first light-emitting layer EML1.

However, the embodiments are not limited thereto. In another embodiment, the photoresist PR (see FIG. 11E) and a portion of the first preliminary light-emitting layer PEML1 (see FIG. 11E) may be removed together in a single process. Here, a single process refers to a process performed as a single step within a same chamber. In an embodiment, for example, the photoresist PR (see FIG. 11E) and a portion of the first preliminary light-emitting layer PEML1 (see FIG. 11E) may be removed together through a single dry ashing process.

Referring to FIGS. 10 and 11H, in the process of forming a second preliminary light-emitting layer (S1405), the second preliminary light-emitting layer PEML2 may be formed on the pixel defining layer PDL and the first electrode EL1. In an embodiment, the second preliminary light-emitting layer PEML2 may be blanket deposited using an open mask. The blanket-deposited second preliminary light-emitting layer PEML2 may also be disposed on the first intermediate protective layer PPL1-1 and the second intermediate protective layer PPL2-1.

Referring to FIGS. 10 and 11I, in the process of forming third and fourth preliminary protective layers (S1406), a third preliminary protective layer 111 and a fourth preliminary protective layer 112 may be successively or sequentially formed on the second preliminary light-emitting layer PEML2. In an embodiment, the third preliminary protective layer 111 and the fourth preliminary protective layer 112 may be blanket deposited using an open mask. In an embodiment of the present disclosure, the fourth preliminary protective layer 112 may have relatively greater etch resistance than the third preliminary protective layer 111, and the third preliminary protective layer 111 may include an inorganic material.

In an embodiment of the present disclosure, the third preliminary protective layer 111 may be disposed between the fourth preliminary protective layer 112 including a metal oxide and the second preliminary light-emitting layer PEML2 to effectively prevent damage to the second preliminary light-emitting layer PEML2 during the formation of the fourth preliminary protective layer 112.

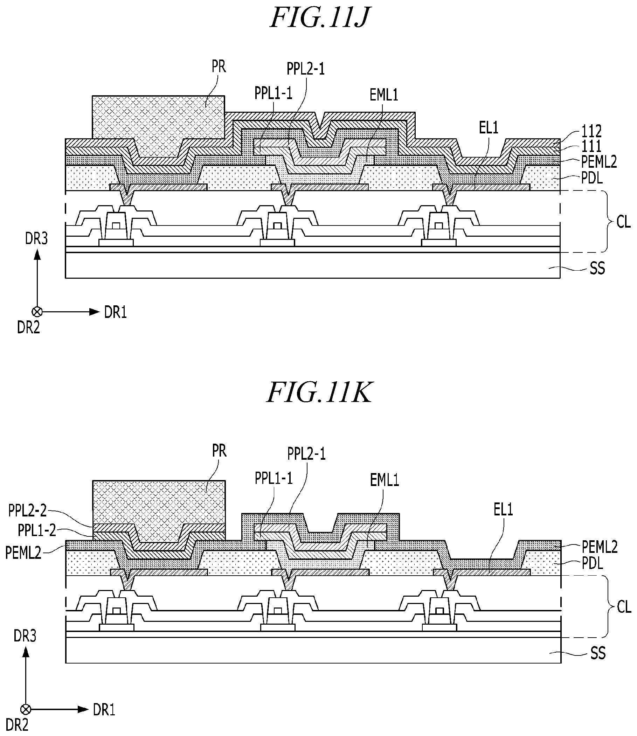

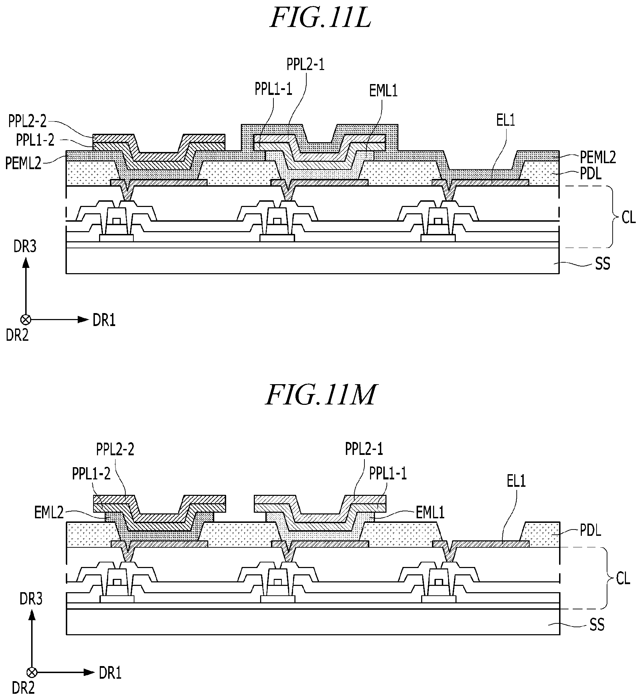

Referring to FIGS. 10 and 11J, in the process of forming third and fourth intermediate protective layers (S1407), a photoresist PR may first be formed in a region corresponding to the second light-emitting diode ED2 (see FIG. 2). Referring to FIG. 11K, an etching process may then be performed to form a third intermediate protective layer PPL1-2 and a fourth intermediate protective layer PPL2-2. Referring to FIG. 11L, the photoresist PR may then be removed.

Referring to FIGS. 10 and 11M, in the process of forming a second light-emitting layer (S1408), an etching process may be performed to remove a portion of the second preliminary light-emitting layer PEML2 and form the second light-emitting layer EML2. Here, the third intermediate protective layer PPL1-2 and the fourth intermediate protective layer PPL2-2 may function as masks for patterning the second light-emitting layer EML2.

However, the embodiments are not limited thereto. In another embodiment, the photoresist PR (see FIG. 11K) and a portion of the second preliminary light-emitting layer PEML2 (see FIG. 11K) may be removed together in a single process. Here, a single process refers to a process performed as a single step within a same chamber. In an embodiment, for example, the photoresist PR (see FIG. 11K) and the portion of the second preliminary light-emitting layer PEML2 (see FIG. 11K) may be removed together through a single dry ashing process.

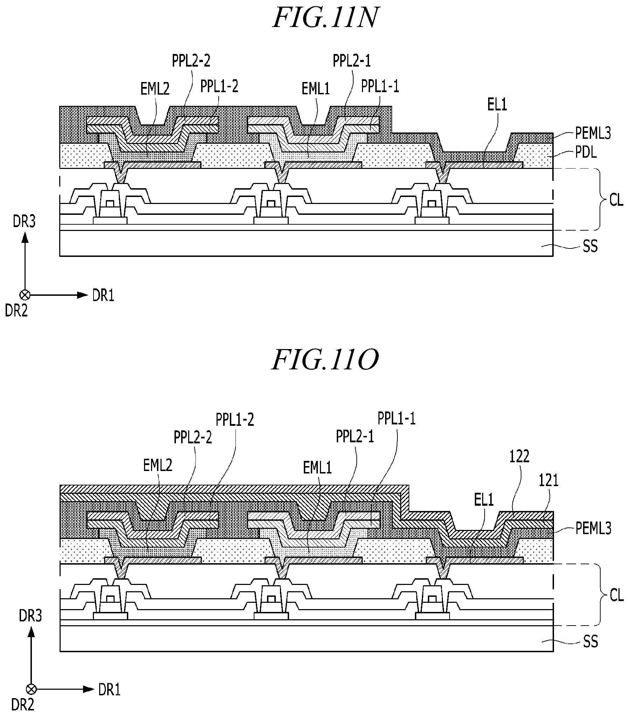

Referring to FIGS. 10 and 11N, in the process of forming a third preliminary light-emitting layer (S1409), a third preliminary light-emitting layer PEML3 may be formed on the pixel defining layer PDL and the first electrode EL1. In an embodiment, the third preliminary light-emitting layer PEML3 may be blanket deposited using an open mask. The blanket-deposited third preliminary light-emitting layer PEML3 may also be disposed on the first intermediate protective layer PPL1-1, the second intermediate protective layer PPL2-1, the third intermediate protective layer PPL1-2, and the fourth intermediate protective layer PPL2-2.

Referring to FIGS. 10 and 11O, in the process of forming fifth and sixth preliminary protective layers (S1410), a fifth preliminary protective layer 121 and a sixth preliminary protective layer 122 may be successively formed on the third preliminary light-emitting layer PEML3. In an embodiment, the fifth preliminary protective layer 121 and the sixth preliminary protective layer 122 may be blanket deposited using an open mask. In an embodiment of the present disclosure, the sixth preliminary protective layer 122 may have relatively greater etch resistance than the fifth preliminary protective layer 121, and the fifth preliminary protective layer 121 may include an inorganic material.

In an embodiment of the present disclosure, the fifth preliminary protective layer 121 may be disposed between the sixth preliminary protective layer 122 containing a metal oxide and the third preliminary light-emitting layer PEML3 to effectively prevent damage to the third preliminary light-emitting layer PEML3 during the formation of the sixth preliminary protective layer 122.

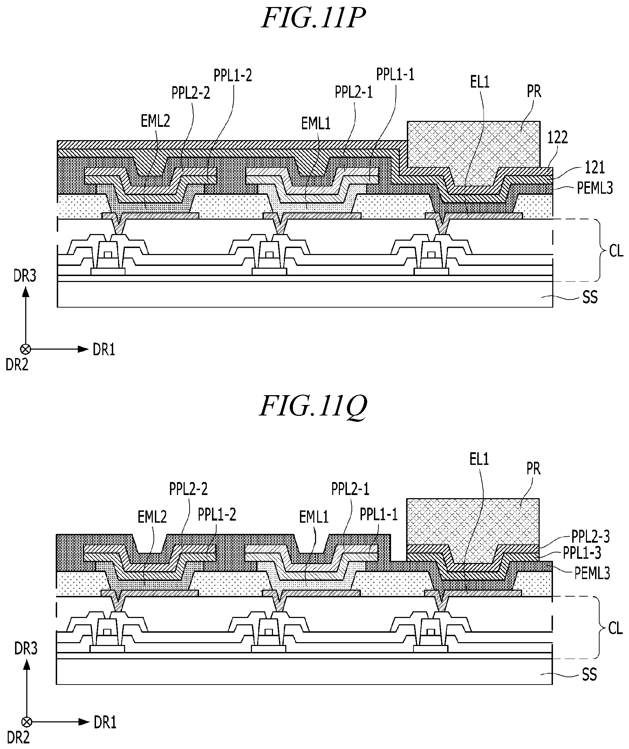

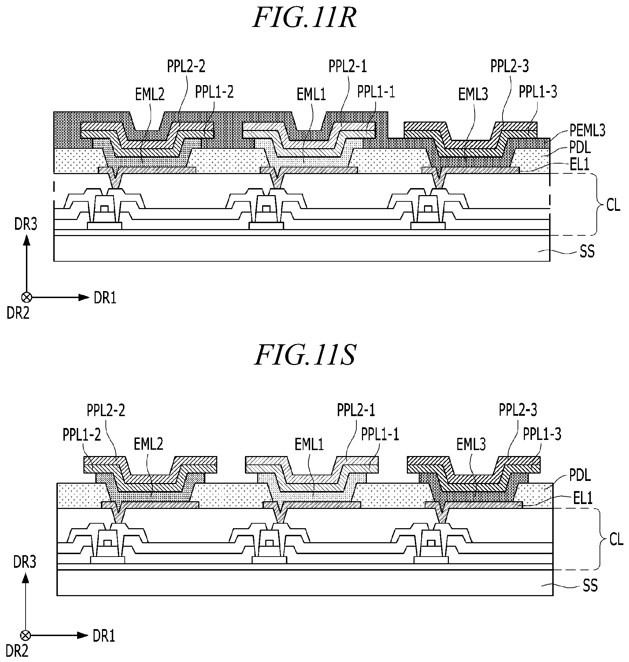

Referring to FIGS. 10 and 11P, in the process of forming fifth and sixth intermediate protective layers (S1411), a photoresist PR may first be formed in a region corresponding to the third light-emitting diode ED3 (see FIG. 2). Referring to FIG. 11Q, an etching process may then be performed to form a fifth intermediate protective layer PPL1-3 and a sixth intermediate protective layer PPL2-3. Referring to FIG. 11R, the photoresist PR may then be removed.

Referring to FIGS. 10 and 11S, in the process of forming a third light-emitting layer (S1412), an etching process may be performed to remove a portion of the third preliminary light-emitting layer PEML3 and form the third light-emitting layer EML3. Here, the fifth intermediate protective layer PPL1-3 and the sixth intermediate protective layer PPL2-3 may function as masks for patterning the third light-emitting layer EML3.

However, the embodiments are not limited thereto. In another embodiment, the photoresist PR (see FIG. 11Q) and a portion of the third preliminary light-emitting layer PEML3 (see FIG. 11Q) may be removed together in a single process. Here, a single process refers to a process performed as a single step within a same chamber. In an embodiment, for example, the photoresist PR (see FIG. 11Q) and the portion of the third preliminary light-emitting layer PEML3 (see FIG. 11Q) may be removed together through a single dry ashing process.

The process of patterning a light-emitting layer and an intermediate protective layer (S140), described with reference to FIGS. 10 and 11B to 11S, is not limited to the described sequence. In an embodiment, for example, the order of forming the first to third light-emitting layers EML1, EML2, EML3 may be changed arbitrarily, and correspondingly, the order of forming the first to sixth intermediate protective layers PPL1-1, PPL2-1, PPL1-2, PPL2-2, PPL1-3, PPL2-3 disposed on the light-emitting layers EML1, EML2, EML3 may also be changed.

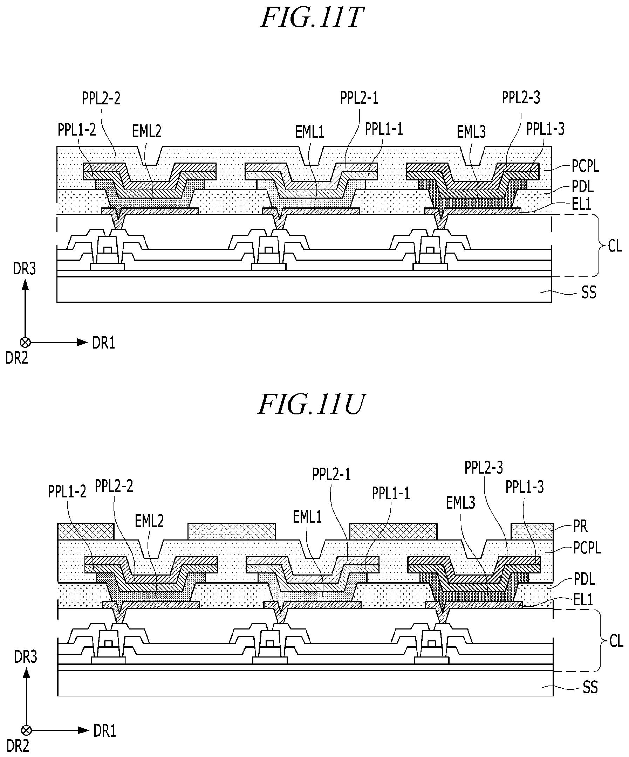

Referring to FIGS. 9 and 11T, in the process of forming a preliminary capping layer (S150), a preliminary capping layer PCPL may be formed to cover the first light-emitting layer EML1, the second light-emitting layer EML2, the third light-emitting layer EML3, the first to sixth intermediate protective layers PPL1-1, PPL2-1, PPL1-2, PPL2-2, PPL1-3, PPL2-3, and the pixel defining layer PDL. In an embodiment, the preliminary capping layer PCPL may be blanket deposited using an open mask.

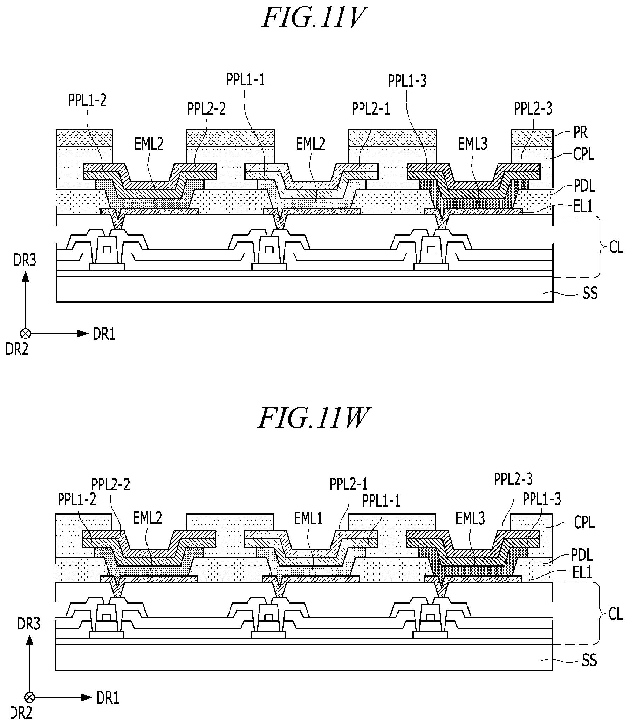

Referring to FIGS. 10 and 11U, in the process of forming a capping layer (S160), photoresists PR may be formed in regions corresponding to the first to third light-emitting diodes ED1, ED2, ED3 (see FIG. 2) on the preliminary capping layer PCPL. Referring to FIG. 11V, an etching process may then be performed to form the capping layer CPL. During the etching process of the preliminary capping layer PCPL, which includes an inorganic material, the second intermediate protective layer PPL2-1, the fourth intermediate protective layer PPL2-2, and the sixth intermediate protective layer PPL2-3, which includes metal oxides and have greater etch resistance than the preliminary capping layer PCPL, may not be etched and may protect the underlying components.

Referring to FIG. 11W, the photoresists PR may then be removed. The capping layer CPL according to an embodiment of the present disclosure may cover the edges of the light-emitting layers EML1, EML2, EML3 to effectively prevent the light-emitting layers EML1, EML2, EML3 from being exposed externally.

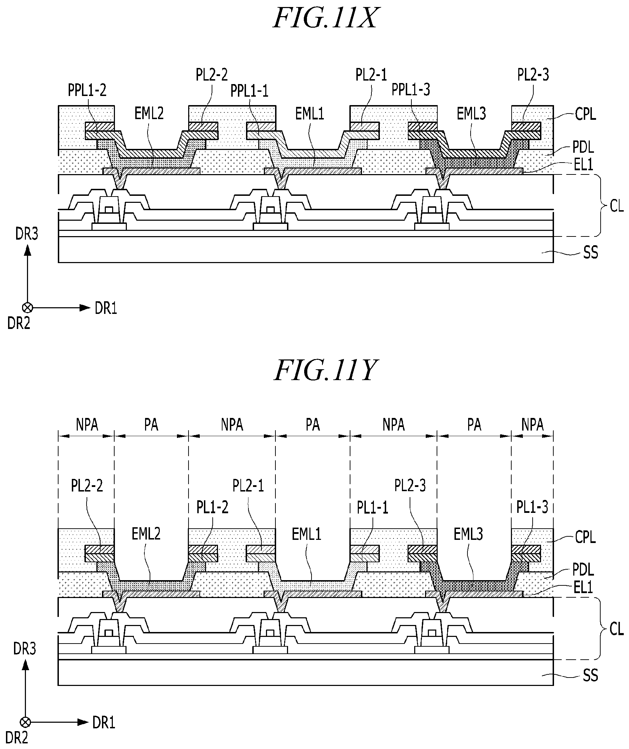

Referring to FIGS. 9 and 11X, in the process of opening a light-emitting region (S170), an etching process may first be performed to form second protective layers PL2-1, PL2-2, PL2-3. In an embodiment, the second protective layers PL2-1, PL2-2, PL2-3 may be formed through a dry etching process.

Referring to FIGS. 9 and 11Y, a subsequent etching process may be performed to form first protective layers PL1-1, PL1-2, PL1-3. In an embodiment, the first protective layers PL1-1, PL1-2, PL1-3 may be formed through a wet etching process. Upon completion of the process of opening a light-emitting region (S170), portions of light-emitting layers EML1, EML2, EML3 corresponding to a light-emitting regions PA may be exposed.

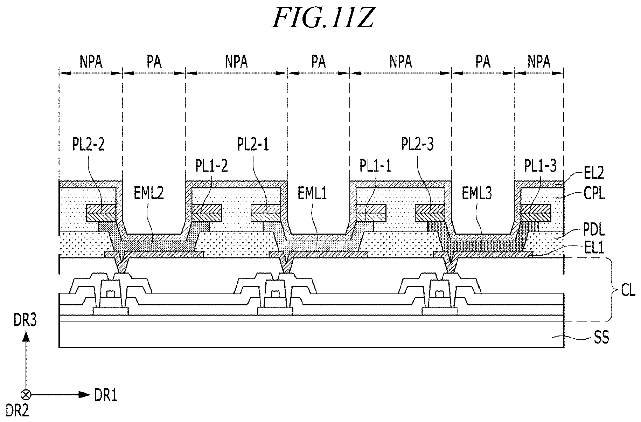

Referring to FIGS. 9 and 11Z, in the process of forming a second electrode (S180), a second electrode EL2 may be formed on the first protective layers PL1-1, PL1-2, PL1-3, the second protective layers PL2-1, PL2-2, PL2-3, the capping layer CPL, and the light-emitting layers EML1, EML2, EML3. In an embodiment, the second electrode EL2 may be blanket deposited using an open mask.

The method for manufacturing a display device according to an embodiment may further include forming a transparent electrode layer (not shown) on the second electrode EL2.

The method for manufacturing a display device according to an embodiment of the present disclosure may form the light-emitting layers EML1, EML2, EML3 through blanket deposition and photolithography processes without using an external mask, as the first to sixth intermediate protective layers PPL1-1, PPL2-1, PPL1-2, PPL2-2, PPL1-3, PPL2-3 function as masks. Such an embodiment provides an advantage for scaling up the display device. Additionally, the capping layer CPL may cover portions of the light-emitting layers EML1, EML2, EML3 to effectively prevent damage to the light-emitting layers EML1, EML2, EML3 and provide a smooth shape that effectively prevents disconnection of the second electrode EL2.

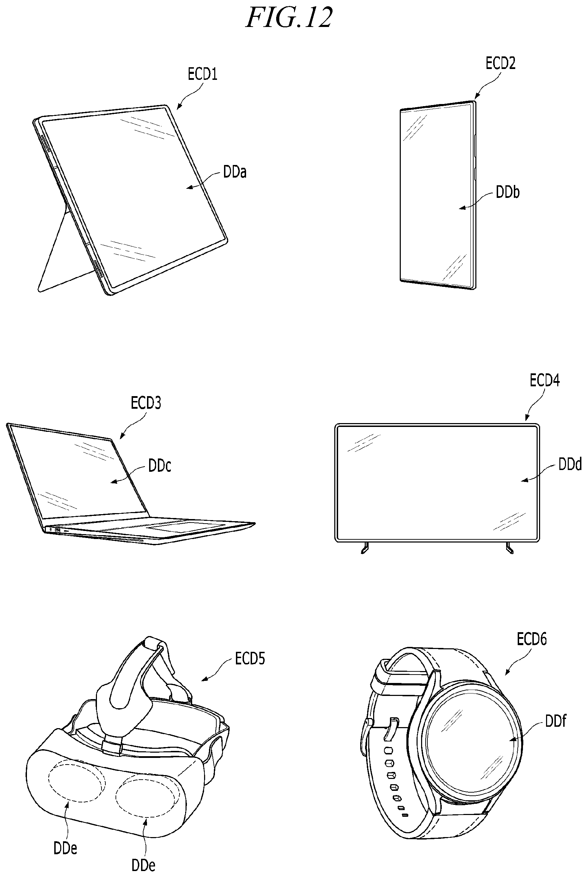

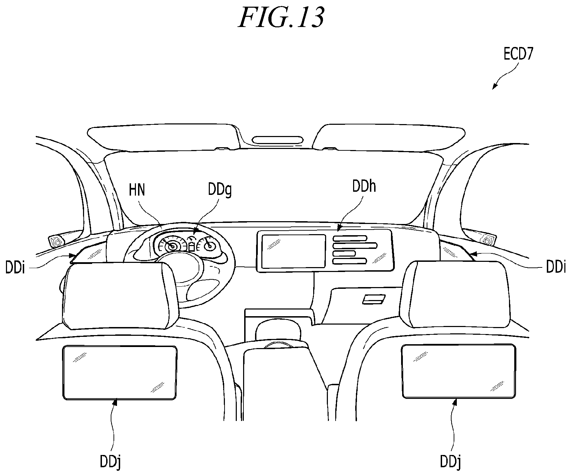

FIGS. 12 and 13 illustrate electronic devices to which a display device according to an embodiment of the present disclosure may be applied. Referring to FIG. 12, a first electronic device ECD1 is a tablet personal computer (PC) that includes a first display device DDa. A second electronic device ECD2 is a portable terminal that includes a second display device DDb. A third electronic device ECD3 is a laptop that includes a third display device DDc. A fourth electronic device ECD4 is a television that includes a fourth display device DDd.

A fifth electronic device ECD5 is a head-mounted display device that includes a fifth display device DDe. A sixth electronic device ECD6 is a digital watch that includes a sixth display device DDf. Referring to FIG. 13, a seventh electronic device ECD7 is a vehicle that includes seventh to tenth display devices DDg, ..., DDj. The seventh electronic device ECD7 is exemplarily illustrated as an automobile, but it is not limited thereto and may include various transportation means or vehicles such as, for example, bicycles, motorcycles, trains, ships, and airplanes.

The seventh display device DDg may be disposed in front of a steering wheel HN in the driver's line of sight and may be used to display instrument panel information, such as the vehicle's driving speed. The eighth display device DDh may be disposed separately on the dashboard and may be used to display information related to the vehicle's control interface, audio, temperature, road conditions, and videos. The ninth display device DDi may be disposed at the driver's side and passenger's side and may be used as digital side rear-view mirrors. The ninth display device DDi may display video footage captured outside the vehicle. The tenth display device DDj may be disposed behind the driver's and passenger's seats and may be used to display visual content, such as videos, to passengers in the rear seats.

In addition to the electronic devices illustrated in FIGS. 12 and 13, the display device DD according to an embodiment of the present disclosure may be applied to electronic devices in every possible field. For example, the display device DD according to an embodiment of the present disclosure may be applied to various electronic devices, such as printers, telephones, wearable devices, digital cameras, camcorders, viewfinders, three-dimensional (3D) displays, video walls that include tiled displays, theaters, signage, medical devices, memory, memory processors, and storage devices.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device (DD) comprising:
a substrate (SS);
a circuit layer (CL) disposed on the substrate (SS);
a first electrode (EL1) disposed on the circuit layer (CL);
a pixel defining layer (PDL) disposed on a portion of the circuit layer (CL) and the first electrode (EL1), wherein an opening (OP) is defined in the pixel defining layer (PDL);
a first light-emitting layer (EML1) disposed on the first electrode (EL1) and a portion of the pixel defining layer (PDL), wherein at least a portion of the first light-emitting layer (EML1) overlaps the opening (OP) in a plan view;
a protective layer (PL) disposed on the first light-emitting layer (EML1) and overlapping the pixel defining layer (PDL) in the plan view;
a capping layer (CPL) covering a side portion of the first light-emitting layer (EML1); and
a second electrode (EL2) disposed on the first light-emitting layer (EML1) and the capping layer (CPL),
wherein the protective layer (PL) comprises:
a first protective layer (PL1) disposed on the first light-emitting layer (EML1); and
a second protective layer (PL2) disposed on the first protective layer (PL1) and having greater etch resistance than the capping layer (CPL).

2. The display device (DD) of claim 1, wherein one side (P1-E) of the first protective layer (PL1), which is relatively distal from the opening (OP), and one side (P2-E) of the second protective layer (PL2), which is relatively distal from the opening (OP), protrude farther away from the opening (OP) than one side (E1-E) of the first light-emitting layer (EML1), which is relatively distal from the opening (OP), does.

3. The display device (DD) of claim 2, wherein a portion of the capping layer (CPL) is disposed beneath a protruded side portion of the first protective layer (PL1), and
wherein the portion of the capping layer (CPL) is in direct contact with the first light-emitting layer (EML1).

4. The display device (DD) of any one of claims 1 to 3, wherein the second protective layer (PL2') has a smaller width than the first protective layer (PL1').

5. The display device (DD) of any one of claims 1 to 4, wherein the capping layer (CPL) is in contact with an upper surface (PDL-UP) of the pixel defining layer (PDL) and an upper surface (PL2-UP) of the second protective layer (PL2).

6. The display device (DD) of any one of claims 1 to 5, wherein a lower surface (EL2-LP) of the second electrode (EL2) is in direct contact with the first protective layer (PL1), the second protective layer (PL2), and the capping layer (CPL).

7. The display device (DD) of any one of claims 1 to 6, further comprising a second light-emitting layer (EML2) spaced apart from the first light-emitting layer (EML1) and disposed on another portion of the pixel defining layer (PDL),
wherein a side surface (E1-E) of the first light-emitting layer (EML1) and a side surface (E2-E) of the second light-emitting layer (EML2) overlap the pixel defining layer (PDL) in the plan view, and
wherein the capping layer (CPL) covers the side surface (E1-E) of the first light-emitting layer (EML1) and the side surface (E2-E) of the second light-emitting layer (EML2).

8. The display device (DD) of any one of claims 1 to 6, further comprising a second light-emitting layer (EML2) spaced apart from the first light-emitting layer (EML1) and disposed on another portion of the pixel defining layer (PDL),
wherein the protective layer (PL) comprises:
a third protective layer (PL3) disposed on the second light-emitting layer (EML2); and
a fourth protective layer (PL4) disposed on the third protective layer (PL3) and having greater etch resistance than the capping layer (CPL),
wherein a side surface (E1-E) of the first light-emitting layer (EML1), a side surface (E2-E) of the second light-emitting layer (EML2), a side surface (P1-E) of the first protective layer (PL1), a side surface (P2-E) of the second protective layer (PL2), a side surface (P3-E) of the third protective layer (PL3), and a side surface (P4-E) of the fourth protective layer (PL4) overlap the pixel defining layer (PDL) in the plan view, and
wherein the capping layer (CPL) covers the side surface (E1-E) of the first light-emitting layer (EML1), the side surface (E2-E) of the second light-emitting layer (EML2), the side surface (P1-E) of the first protective layer (PL1), the side surface (PE-2) of the second protective layer (PL2), the side surface (PE-3) of the third protective layer (PL3), and the side surface (P4-E) of the fourth protective layer (PL4).

9. The display device (DD) of any one of claims 1 to 8, wherein the first protective layer (PL1) comprises an inorganic material.

10. The display device (DD) of claim 9, wherein the inorganic material comprises at least one selected from silicon nitride (SiNx), silicon oxynitride (SiOxNy), and silicon oxide (SiOx).

11. The display device (DD) of any one of claims 1 to 10, wherein the second protective layer (PL2) comprises a metal oxide.

12. The display device (DD) of claim 11, wherein the metal oxide comprises at least one selected from indium tin oxide (ITO), indium zinc oxide (IZO), indium gallium zinc oxide (IGZO), indium tin gallium oxide (ITGO), or indium tin gallium zinc oxide (ITGZO).

13. The display device (DD) of any one of claims 1 to 12, wherein the capping layer (CPL) is defined by a single inorganic layer.

14. The display device (DD) of any one of claims 1 to 13, wherein the capping layer (CPL) and the pixel defining layer (PDL) each comprise an inorganic material, and
wherein the capping layer (CPL) and the pixel defining layer (PDL) are in contact with each other.

15. The display device (DD1) of any one of claims 1 to 14, further comprising a transparent electrode layer (TCO) disposed on the second electrode (EL2).
